# EUROPEAN PATENT APPLICATION

(11) **EP 1 816 104 A1**
(43) Date of publication of application: **08.08.2007**
(21) Application number: 07101932.7
(22) Date of filing: 07.02.2007
(51) Int. Cl.: C01B 37/02

(54) **UV cure for functionalization and hydrophobization of zeolite**

(30) Priority: 07.02.2006 US 771073 P
(71) Applicant: Interuniversitair Microelektronica Centrum (IMEC), 3001 Leuven (BE); Katholieke Universiteit Leuven (KUL), 3000 Leuven (BE)
(72) Inventor: IACOPI, Francesca, 3001 Leuven (BE); ESLAVA FERNANDEZ, Salvador, 3000 Leuven (BE)
(74) Representative: pronovem

(57) **Abstract**

A method is disclosed to make pure-silica-zeolite films more implementable as low-k material in semiconductor processing.

Specifically, the pure-silica-zeolite films obtained are more hydrophobic, homogeneous and with no cracks.

The method is a UV cure, preferably said UV cure is performed at temperatures at higher than the deposition temperature. The UV-assisted cure removes the organic template promoting organic functionalization and silanol condensation making pure-silica-zeolite films hydrophobic.

Moreover, the zeolite material will also be mechanical stronger.

## Description

### Field of the Invention

The present invention relates to a method for making zeolite-films more hydrophobic.

The present invention is related to the field of semiconductor processing.

The present invention is further related to the field of membranes and membrane fabrication.

More specifically the invention relates to a method for improving the properties of zeolites and/or zeolite-like materials to be used as dielectric material or as membranes. More particularly, the invention relates to a method for improving the properties of pure-silica-zeolite materials, to be used as dielectric material in between interconnects in semiconductor devices.

### Background of the Invention

Zeolites, as porous materials, have found various commercial uses in the catalysis, adsorption, and ion exchange industries. Besides, zeolites find more and more applications in other areas because of their superior mechanical properties and porosity.

Pure-silica zeolites are strong candidates for replacing low-dielectric constant (low-k) material for next-generation microprocessors. In order to survive the chemical-mechanical processing steps, the semiconductor industry generally acknowledges a minimum threshold value of 6 GPa (Young's Modulus) for these materials.

Pure-silica zeolites have been proposed as low dielectric constant materials for interconnects the first time by Yan et al. (US 6,630,696). The advantage of using pure-silica-zeolites as low-k material is the combination of crystallinity and porosity such that superior mechanical properties and high porosity can be obtained. The final properties can be tuned by using e.g. different crystalline structure (MFI, BEA, MEL...), by tuning the crystalline/amorphous ratio in the synthesis of the films or by adding porogens to the pure-silica zeolite suspension. Typically, pure-silica zeolites have k values below 2.7.

A main showstopper however for the actual use of pure-silica zeolite materials as low-k films in interconnects is their hydrophilicity (contact angle with H₂O typically lower than 20 degrees) which is a main issue in low-k dielectrics. The adsorption of moisture within the inner pores of the pure-silica-zeolites can results in a significant increase of the dielectric constant because water has a very high k value (k=80). Hence, it is important to make the pure-silica zeolites material very hydrophobic to maintain a low-k value.

Post-deposition treatments were proposed in prior art to increase the hydrophobicity of a zeolites film. For example, vapor-phase silylation using chlorotrimethylsilane or hexamethyldisilazane to increase the hydrophobicity of a zeolite film. Since the pore size of silica zeolites is very small, the chlorotrimethylsilane molecules may encounter diffusion limitations and hence difficulties to access the silanol groups inside the zeolites micropores leading to limited increase in hydrophobization.

Dattelbaum et al. (J. Phys. Chem. B, 109 (2005) pp 14551) used a UV treatment for removing the organic template in a zeolites film after depositing said zeolite film; however no organic functionalization was observed and hence no improvement of the hydrophobicity of the zeolite film occurred because only a photochemical decomposition and desorption of the organic material was performed.

Li et al. (Chem. Mater. 2005, 17, 1851-1854) proposes an organic functionalization of the zeolites crystals (and amorphous silica) during the synthesis of the zeolite nanoparticle suspension (prior to spinning). However the final zeolites film obtained after incorporation of said organic molecules to the silica matrix has a lower thermal stability and the increase in hydrophobicity is rather limited.

Therefore there is still a need for an efficient method for increasing the hydrophobicity of a zeolite film without altering characteristics such as thermal stability and mechanical strength.

### Summary of the Invention

The present invention provides a method for improving the hydrophobicity of a zeolite film comprising the steps of:
- providing a zeolite synthesis composition comprising a silica source and an organic template,
- forming onto a support a zeolite film,
- subjecting said formed zeolite film to, simultaneously, UV irradiation and thermal activation.

Preferably, said zeolite film is formed on said support by an in-situ crystallization process, a dip-coating process or a spin-on process. More preferably said zeolite film is formed on said support by a spin-on process.

Preferably, a suspension of zeolite nanocrystals, preferably with particles size of less than 100 nm, more preferably comprised between 40 nm and 70 nm, even more preferably between 50 nm and 70 nm, is deposited on said support for forming said zeolite film.

Preferably, said suspension of zeolite nanocrystals further comprises smaller silica nanoparticles or clusters of said smaller silica nanoparticles.

In a method according to the invention, said zeolite film can be a MEL type, BEA type, or preferably a MFI type.

Preferably, said zeolite film is a pure-silica-zeolite film.

In a method according to the invention, said support is preferably a substrate, a polymeric support, a porous alumina support, or a ceramic support.

In a method according to the invention, said substrate refers to any substrate suitable for the manufacture of semiconductor devices and integrated circuits. The term also refers to the substrate during or after any of the various stages of treatment through which it goes during the process of semiconductor device and/or integrated circuit manufacture, for example during or after the deposition of dielectric or of interconnect conductors.

A preferred example of said (semiconductor) substrate is a wafer, more particularly a silicon wafer.

Preferably, said silica source comprises (or consists of) an organic silica such as tetraethyl orthosilicate (TEOS) and/or tetramethyl orthosilicate (TMOS), or an inorganic silica such as fumed silica, silica gel, or colloidal silica.

Preferably, said organic template comprises (or consists of) an organic hydroxide such as a quaternary ammonium hydroxide, such as tetrapropyl-ammonium hydroxide (TPAOH), tetraethylammonium hydroxide (TEAOH), triethyl-n-propyl ammonium hydroxide, or benzyl-trimethylammonium hydroxide.

Preferably, the temperature for said thermal activation is higher than 100°C, preferably higher than 150°C, 200°C or 300°C, more preferably is comprised between about 350° and about 550°C. More particularly, the temperature for said thermal activation is about 425°C.

In a method according to the invention, the wavelengths of said UV irradiation are preferably lower than 300 nm, preferably lower than 270 nm; more preferably comprised between 170 nm and 250 nm.

A method according to the invention can further comprise, before the UV irradiation and thermal activation, a drying step.

The present invention also relates to the use of a method of the invention for functionalizing a zeolite film, and more particularly a pure-silica zeolite film.

A method of the invention can also be used for preventing the cracks formation in a zeolite film, and more particularly in a pure-silica zeolite film.

A method of the invention can also be used for enhancing the homogeneity of a zeolite film, and more particularly of a pure-silica zeolite film.

A method of the invention can also be used for enhancing the adhesion of a zeolite film, and more particularly of a pure-silica zeolite film, onto a support.

A method of the invention can also be used for preventing the delamination phenomenon in a zeolite film, and more particularly in a pure-silica zeolite film.

A method of the invention can also be used for increasing the mechanical strength of a zeolite film, and more particularly of a pure-silica zeolite film.

In particular, a method of the invention can be used for obtaining any combination of (2 or 3 or more of) these different effects or for obtaining all these different effects.

Another object of the present invention is a zeolite film, more particularly a pure-silica zeolite film, obtainable by a method according to the invention, and its use as a low-k material (i.e. a material having a dielectric constant lower than the dielectric constant of SiO₂), in particular in a semiconductor processing method or in a semiconductor device.

Another object of the present invention is a zeolite film or a zeolite product obtainable by a method according to the invention, and its use as a membrane.

Another object of the present invention is a semiconductor device comprising a zeolite film, more particularly a pure-silica zeolite film, according to the invention.

### Short Description of the Drawings

All figures/drawings are intended to illustrate some aspects and embodiments of the present invention. Devices are depicted in a simplified way for reason of clarity. Not all alternatives and options are shown and therefore the invention is not limited to the content of the given drawings. Like numerals are employed to reference like parts in the different figures.

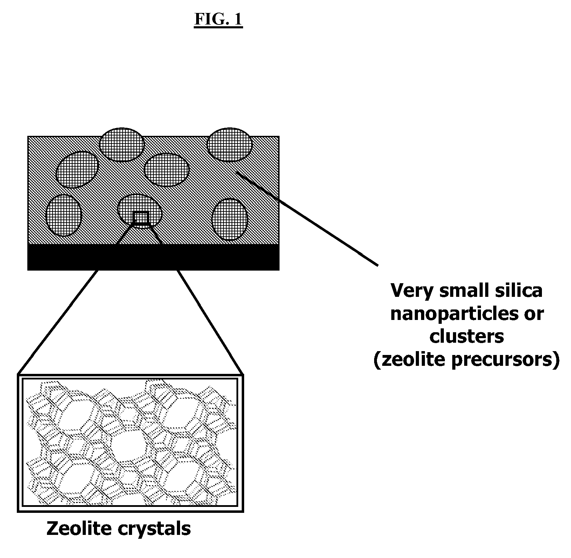

Figure 1 is a schematic diagram of a spin-on pure-silica-zeolite film.

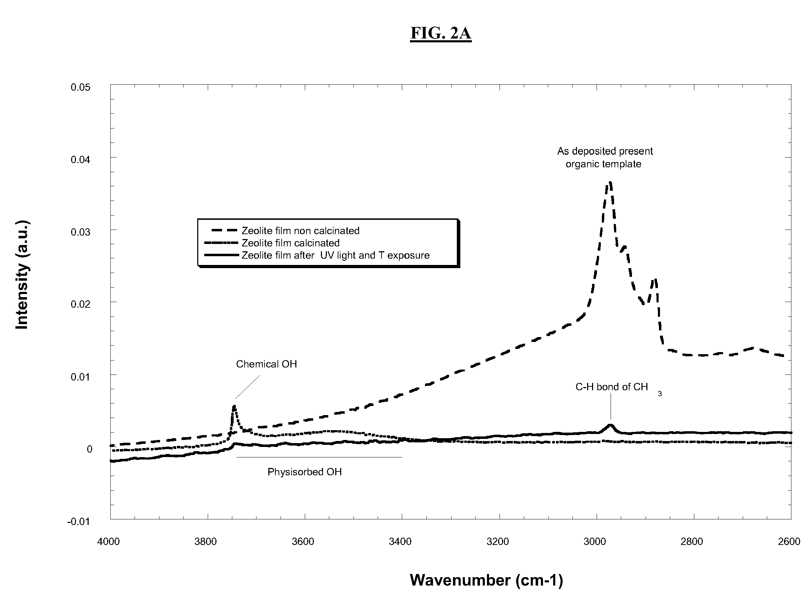

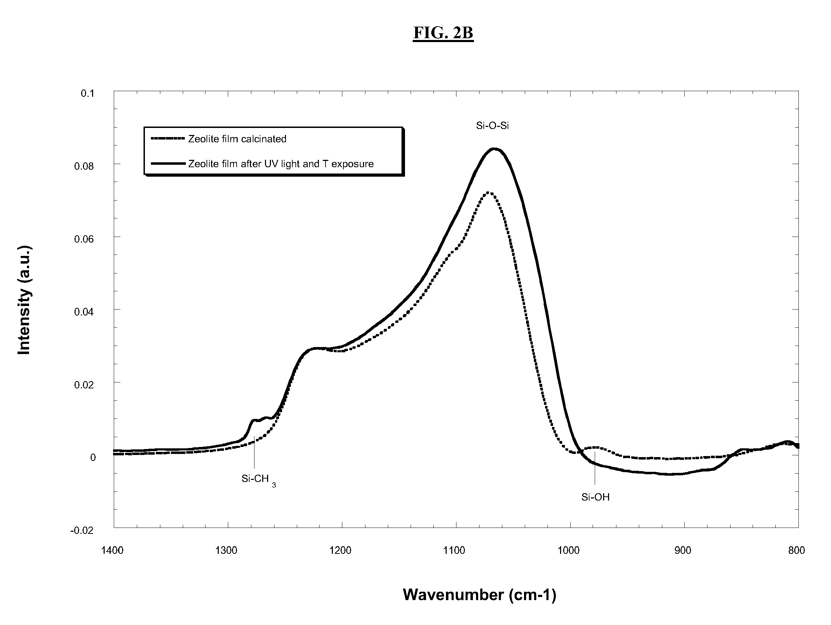

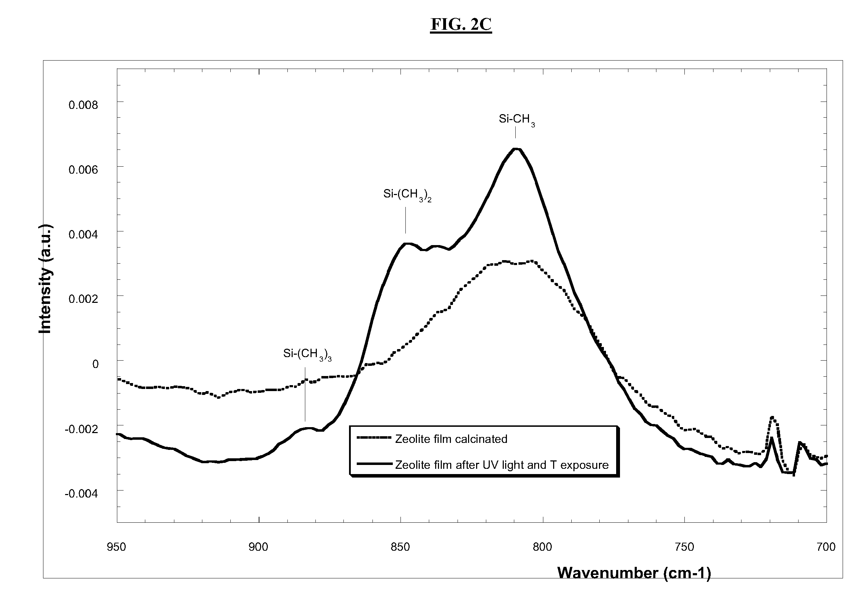

Figure 2A, 2B and 2C are Fourier Transform Infrared Spectroscopy (FTIR) spectra illustrating the use of UV light during (simultaneously with) the thermal removal of the template. As shown in Figure 2A, the UV light exposure and the thermal activation according to the invention results in almost total removal of OH bonds (seen at 3400-3760 cm⁻¹). Figure 2A also shows a peak at 2970 cm⁻¹ indicating C-H bonds. As shown in Figure 2B, the UV light exposure and the thermal activation according to the invention results in almost total removal of OH bonds (seen at 980 cm⁻¹), the formation of Si-CH₃ bonds (seen at 1277 cm⁻¹) and an increase of Si-O-Si bondings (seen at approximately 1070 cm⁻¹ and relates to network bonding having a positive effect on mechanical properties). Figure 2C shows IR peaks related to the organic functionalization relating to different peaks in range of 800 up to 900 cm⁻¹.

Figure 3 illustrates adsorption (ads) / desorption (des) of toluene in spin-on pure-silica zeolite films exposed to the UV-light and thermal activation according to the present invention obtained by Ellipsometric porosimetry. Total toluene percentage adsorbed is representative of the total porosity of the films.

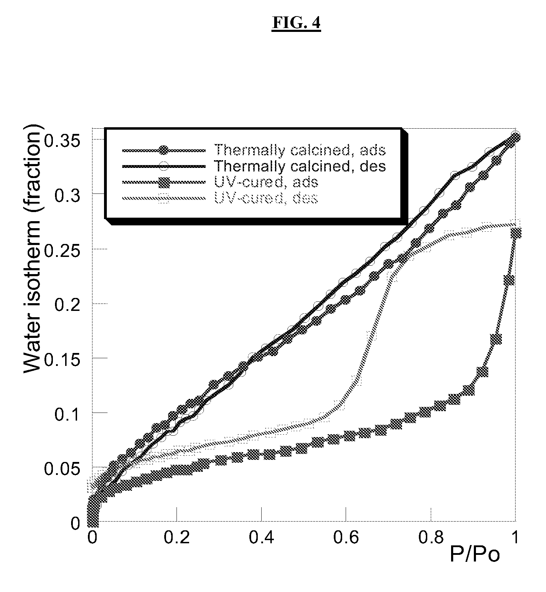

Figure 4 illustrates adsorption (ads) / desorption (des) of water on a pure-silica-zeolite film exposed to the UV-light and thermal activation according to the present invention from Ellipsometric measurements.

Figure 5A shows SEM image of a pure-silica zeolite film after removal of the (organic) template by thermal treatment (showing clearly unwanted cracks in the film). Figure 5B shows SEM image of a pure-silica zeolite film obtained by the method of the present invention (no cracks visible).

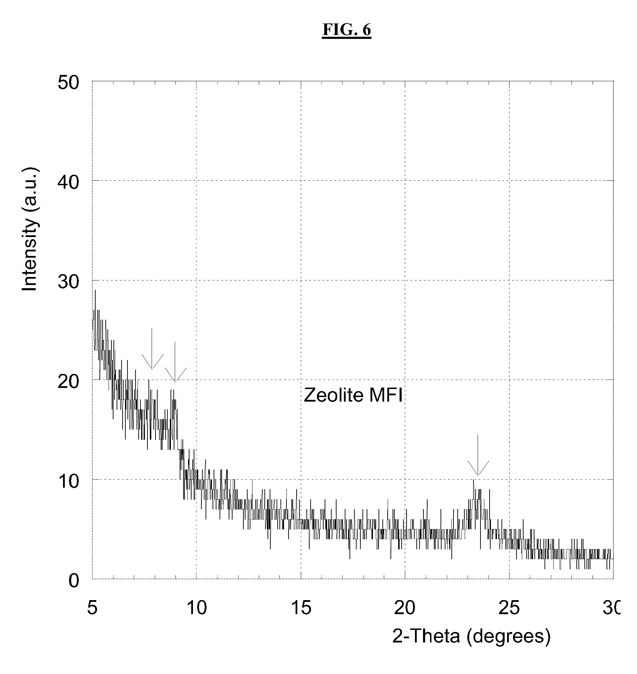

Figure 6 shows standard incidence XRD results on a reference spin-on silica-zeolite film. The presence of peaks at 2-Theta around 8, 9 and 23 degrees show the presence of zeolite MFI. However, the low intensity of these peaks suggests that the crystallinity of the film is quite low. The reason is the use of the small silica nanoparticles or clusters as 'glue holding entities' of the zeolite nanocrystals and the deficient crystallinity of the zeolite nanocrystals.

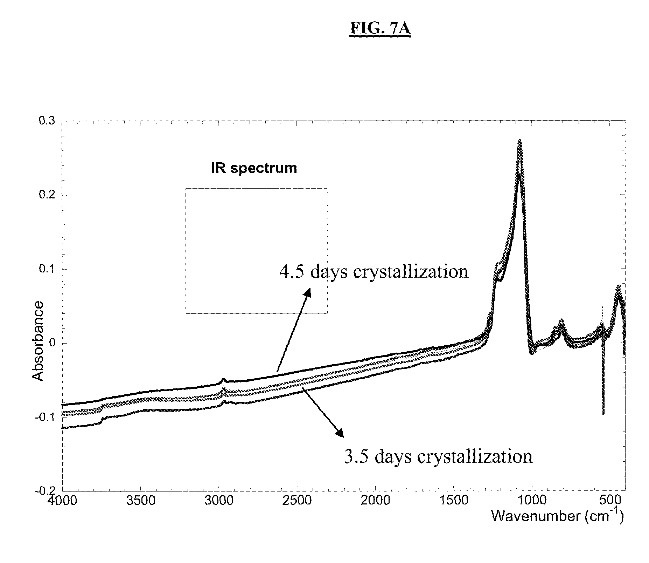

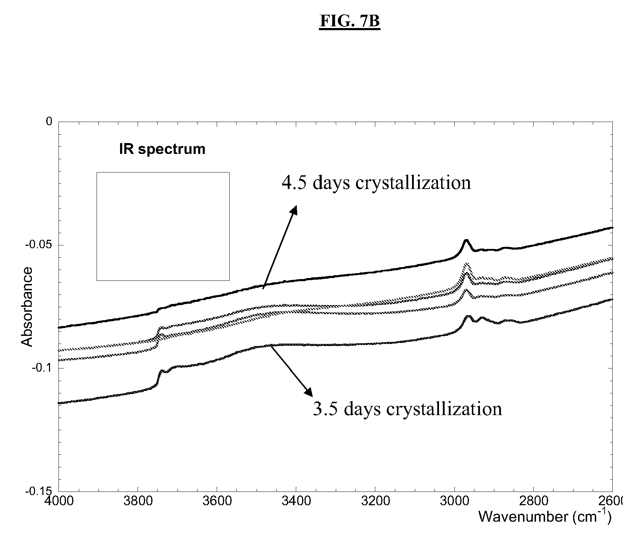

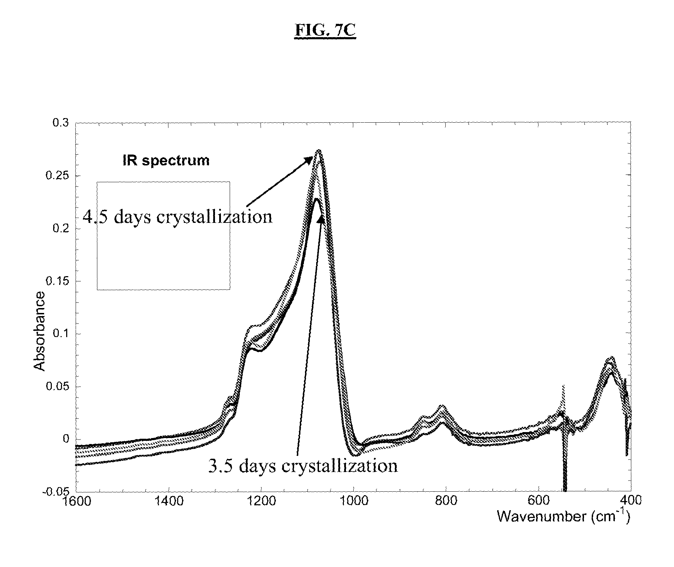

Figure 7 (fig. 7A-7C) illustrates FTIR charts demonstrating that the lowest silanol content is found after UV-cure for spin-on zeolites with higher crystallinity ratio, that is, when a longer crystallization time is performed to obtain the pure-silica zeolite suspension.

### Detailed Description of the Invention

The following description and examples illustrate various embodiments of the present invention. It will be appreciated that there are numerous variations and modifications of these embodiments that are possible.

The term "pure-silica zeolites", in the context of the present invention, refers to zeolites (substantially) free of Al.

The term "template" used in the present application refers to the structure-directing agent (e.g. tetrapropyl-ammonium) added to the silica source for the zeolite formation.

The present invention provides a method for:
- functionalizing a zeolite film,
- improving the hydrophobicity of a zeolite film,
- preventing cracks formation in a zeolite film,
- enhancing the homogeneity of a zeolite film,
- enhancing the adhesion of a zeolite film,
- increasing the mechanical strength of a zeolite film, and/or
- preventing delamination of a zeolite film.

A method of the invention comprises the steps of:
- providing a zeolite synthesis composition comprising a silica source and an organic template,
- forming, onto a support, a zeolite film,
- subjecting said formed zeolite film to, simultaneously, UV irradiation and thermal activation.

More particularly, a method of the invention comprises the steps of:
- providing a zeolite synthesis composition comprising a silica source and an organic template,
- forming, onto a support, a pure-silica-zeolite film,
- subjecting said formed pure-silica-zeolite film to, simultaneously, UV irradiation and thermal activation.

In a method of the invention, said pure-silica-zeolite film can have a MFI, BEA, MWW, LTA, CHA, or MTW structure.

In a method of the invention, said pure-silica-zeolite film, can be formed by a spin-on process or any alternative processes such as in-situ crystallization or dip coating.

Preferably, said pure-silica-zeolite film is formed by a spin-on process.

In a preferred spin-on process according to the invention, a pure-silica zeolite suspension comprising pure-silica zeolite nanocrystals (e.g. exhibiting particles size of less than 100 nm, more particularly of 40nm-70nm, even more preferably of 50nm-70nm) and smaller silica nanoparticles or clusters, is deposited upon said support.

Although bigger crystals have better crystallinity, small nanocrystals are necessary for the homogeneity of the films. The synthesis conditions are thus optimized to obtain a small crystal size, sacrificing crystallinity, and generating dangling bonds that contribute to the hydrophilicity of the films.

It was found that the UV irradiation combined with the temperature treatment reduce these dangling bonds.

Said smaller silica nanoparticles, or clusters of said smaller silica nanoparticles, originate from the hydrolysis of the silica source (e.g. TetraEthylOrthoSilicate (TEOS)) in the presence of said organic template (e.g. Tetrapropyl-ammoniumhydroxide (TPAOH)). They are generated during zeolite synthesis when said zeolite synthesis composition is a clear solution (i.e. a clear homogeneous solution wherein only subcolloidal and discrete particles are present).

There are different theories about the mechanism of formation of the zeolite nanocrystals from a clear solution.

For example, in the mechanism proposed by Kirschhock and co-authors, it is explained that these small silica nanoparticles have slab shape, crystalline structure and aggregate till forming zeolite nanocrystals. Said smaller silica nanoparticles or clusters, due to their small size, have a high surface area and consequently, high quantity of silanol groups.

In spite of having a high surface area, their small size permits to obtain homogeneous films because they are able to fill the voids among the pure-silica zeolite nanocrystals (e.g. 40nm-70nm, or preferably 50nm-70nm). Said smaller nanoparticles work as 'glue holding entities' of the pure-silica zeolite nanocrystals. However, their presence makes these films hydrophilic.

In comparison with the pure-silica zeolite nanocrystals, the part of the films containing the small silica nanoparticles or clusters have much higher concentration of dangling bonds because of their high internal surface area. Hence, this part of the film could have more active sites for the combined UV and thermal treatment.

Indeed, it was found that the combined use of UV irradiation (also referred to herein as UV light, UV treatment or UV exposure) and thermal activation (also referred to herein as thermal treatment or thermal exposure) is a key-factor in the invention to realize organic functionalization, i.e. the photochemical and thermochemical reaction between the organic species and the silica matrix. Said combination of UV irradiation and thermal activation is also referred to herein as "UV-curing" or "UV-cure".

This organic functionalization renders the film hydrophobic.

After forming said pure-silica zeolite film onto said support, and before the UV-curing, a drying step can be performed.

Said drying step, if any, is preferably performed at about 80°C (e.g. for a few hours), and should not totally remove the organics.

Although not preferred, it is also possible to perform an additional heating step, or bake step, after the drying step, still before the UV-curing, for removing part of the organic template present in the pure-silica-zeolite layer, but special care needs to be taken during said bake step to avoid total removal of the organic template, such that organic functionalization during subsequent UV-curing can still take place. Said bake step can be performed, for example, at approximately 300°C.

Indeed, in a method of the invention, there is preferably no further thermal treatment(s) (i.e. no other thermal treatment than the one combined with the UV irradiation). In particular there is no said drying step, and more particularly no said additional bake step.

It was observed that the absence of further thermal treatment(s) results in an optimal homogeneity of the pure-silica zeolite film and in the absence of cracks in the pure-silica zeolite film.

In a method of the invention, the UV exposure is preferably performed at low wavelengths. More particularly, the wavelengths are lower than 300 nm, preferably lower than 270 nm, e.g. about 250nm, more specifically in the range of 170 nm to 250 nm.

In a method of the invention, during the UV exposure, the sample must be submitted to a temperature allowing said photo- and thermal-chemical reaction. Said temperature is preferably higher than 100°C, more preferably higher than 150°C, 200°C, or 300°C, even more preferably is about 425 °C for ensuring good efficiency of the UV treatment.

If a bake step (using for example a bake temperature of around 300°C) was performed prior to the UV-curing,, the temperature in the tool during the UV light exposure is preferably higher than the bake temperature, most preferred around 400°C, for example 425°C.

Said UV-curing is preferably performed immediately (i.e. with no intermediate step) after the film formation. When the UV-curing is performed after a partial removal of the organic template by means of thermal treatment, the final homogeneity is not optimal and/or some cracks are present.

It seems that, as a result of UV-curing, the O-H bond in the chemically bonded silanol groups (Si-OH) are drastically decreased due to the formation of Si-O-Si cross-linking bridges, Si-CH₃ and/or Si-O-CH₃.

By using UV-curing, part of the carbon present in the organic template is kept and found back linked to the silica matrix in the form of Si-CH₃ and/or Si-O-CH₃ functional groups, known to be effective hydrophobic groups.

The combination of removing the silanol groups and creating Si-O-Si, Si-CH₃ and/or Si-O-CH₃ groups leads to a significant improvement in hydrophobicity. The lowest silanol content after UV-cure is found for spin-on zeolites with higher crystallinity ratio, more particularly when a longer crystallization time is performed to obtain the pure-silica zeolite suspension.

To investigate the improvement in hydrophobicity of the pure-silica zeolite films, contact angle measurements can be used, preferably performed with a polar solvent such as H₂O.

The results of said contact angle measurements (with water) indicate an improvement going from approximately 5 degrees (reference without UV-curing, almost completely wetable) up to values higher than 100 degrees (typically 120 deg) after using the UV-cure of the present invention.

The increase of hydrophobicity is further related to large reduction of trapped physisorbed moisture, said moisture preferably being attracted towards chemically bonded silanol groups.

Furthermore, the enhancement of Si-O-Si cross-linking observed by FTIR increases the final mechanical properties of the zeolites film.

The degree of functionalization when carrying out a method of the present invention is dependent on the degree of crystallinity of the pure-silica-zeolite film used.

Adding organic molecules to the zeolite film before UV light and temperature exposure, for example adding methyltrimethoxysilane to the synthesis solution, may further increase the organic functionalization and consequent hydrophobization.

The UV-treated pure-silica zeolites (with improved hydrophobicity) (i.e. the pure-silica zeolite film(s) obtainable by a method of the invention) can be used as low-k dielectric material(s) in between interconnect structures of a semiconductor device.

The UV-treated pure-silica zeolites (with improved hydrophobicity) (i.e. the pure-silica zeolite film(s) or product(s) obtainable by a method of the invention) can be used as membranes.

The present invention can also be described as a new post-deposition method to induce hydrophobization of spin-on silicalite-1 films during the removal of the organic template.

The method comprises of a wide-band UltraViolet (UV) irradiation combined with thermal activation.

The hydrophobization is obtained because the UV-cure decreases drastically the quantity of silanols and makes the organic template react with the silica matrix forming hydrophobic Si-CH₃ groups while desorbing. The Si-O-Si bond angle decreases and moreover, the formation of cracks larger than 50 nm is avoided.

The method of the invention comprises the step of exposing the pure-silica-zeolite film to UV light and temperature. Said UV cure is done after the deposition or formation of a pure-silica zeolite film onto a support, and more particularly onto a substrate.

Several methods are described in literature to perform the deposition/formation of a pure-silica zeolite film onto a substrate. Preferred methods are e.g. spin-on or in-situ crystallization.

Said pure-silica zeolites can be made by combining a (commercially available) silica source with a (commercially available) organic zeolite-forming structure-directing agent (also referred to as organic template).

For example, pure-silica zeolites formed by a method of the invention can have a MFI, BEA, MWW, LTA, CHA, MTW structure.

The deposition/formation can be done by in-situ crystallization or by spinning a suspension containing pure-silica-zeolite nanocrystals with 'glue holding entities' such as smaller silica nanoparticles (precursors of these nanocrystals).

After the deposition step, and before the UV-cure, the pure-silica zeolite film may be dried. Said drying step can be performed for example overnight (several hours). The substrate can be heated during drying, e.g. up to 80°C, but it should not remove totally the organics.

Optionally, but not preferred, there can be an additional bake step before performing the UV-cure. Said bake step is used to remove part of organic material present in the pure-silica-zeolite film. Said organic material is originating from the template and/or solvent used in the starting solution (i.e. the zeolite synthesis composition). Special care needs to be taken that there is still a residual amount of organic template available in the pure-silica-zeolite film to obtain organic functionalization during subsequent UV-cure.

Preferably, no further thermal treatment (e.g. additional bake) is performed after the drying step.

It is recommended not to do a pre-UV thermal step, such as an additional bake, such that an optimal homogeneity is obtained and absence of cracks is seen.

The UV irradiation is preferably performed at wavelengths smaller than 300 nm. Applying said wavelengths can break the O-H bonding. Additionally the substrate together with the pure-silica zeolite film are heated during the UV treatment.

The removal of silanol groups makes it possible to create new Si-O-Si cross-linking bridges.

Also, following UV-cure, part of the C present in the organic component of the template is kept and found back in the form of Si-CH₃ and/or Si-O-CH₃ functional groups (referred to as organic functionalization), said -CH₃ and/or -O-CH₃ groups known to be effective hydrophobic groups.

Solvents used (if still presents) may have contributed to the organic functionalization but less likely, due to their high volatility.

During organic functionalization, Si-OH bonds are drastically decreased and new bonds appear, Si-CH₃ and/or Si-O-CH₃. An advantage of creating Si-CH₃ and/or Si-O-CH₃ bondings in the films is the fact that the density of the films is still low.

The UV-cure of pure-silica-zeolite films, with sufficient amount of organic template, results in a significant improvement of hydrophobicity due to the removal of hydroxyl groups and the organic functionalization.

The removal of hydroxyl groups by means of silica condensation to form hydrophobic siloxane and Si-O-Si bond avoids moisture adsorption but has the tendency to increase the density of a pure-silica-zeolite film.

Said Si-O-Si bondings create new cross-linking bridges in the pure-silica-zeolite film, leading towards higher mechanical strength. The decrease of the large Si-O-Si bonds lead towards improved mechanical properties.

To keep the density of the material low, it is preferred to have also significant degree of organic functionalization (meaning incorporation of "CH₃" groups).

The density of a material, more specifically of a zeolites type material, is influenced by formation of firstly Si-O-Si bonds by silanol condensation which increases the density due to the (increased level) cross-linking.

Secondly, by the formation of Si-CH₃ or Si-O-CH₃, this also increases the density as more atoms fill the pores.

With the UV-cure according to the invention, all the above mentioned effects end up in an increase of density.

The introduction of new cross-linking bridges during UV-cure is mainly taking place in the amorphous part of the films because the amorphous part has significant higher concentration of silanol groups. Said Si-O-Si bondings create new cross-linking bridges in the pure-silica-zeolite film, leading towards higher mechanical strength.

Improvement in hydrophobicity can be investigated by means of ellipsometric porosimetry measurements (also referred to as ellipsometric measurements) as described in EP1722213 by Baklanov et al.

Alternatively contact angle measurements with H₂O can be performed. For a reference material (having complete wetting with water) the contact angle is typically ~5 degrees. After UV-cure of the pure-silica zeolite film, contact angle values of 100 degrees and higher can be obtained (typically 120 deg).

The removal of chemically bonded silanols can also be investigated by FTIR showing that after UV-cure a pure-silica zeolite film has a large reduction of trapped physisorbed moisture.

The organic functionalization and consequent hydrophobization may be further increased by adding more organic molecules to the zeolite film before UV light and temperature exposure to promote higher organic functionalization, for example methyltrimethoxysilane.

The pure-silica zeolite films after UV cure according to the present invention can be used as low-k dielectric material (i.e. material having a dielectric constant lower than the dielectric constant of SiO₂) in between (metallic) interconnect structures in a semiconductor device.

### EXAMPLES

### Example 1: Depositing a pure-silica-zeolite film

Zeolite films may be deposited in several ways: in-situ crystallization, spin-on of a zeolite particle suspension, dip-coating of a zeolite particle suspension, etc.

As described in this example and used as sample in further examples, spin coating will be used as deposition method and is performed as described below.

For the examples, spin-on pure-silica-zeolite MFI films are following the recipe proposed by Yan et al. (US 6,630,696).

According to that recipe, TEOS is the silica source and TPAOH the organic template. In that recipe, a clear solution is obtained with a molar composition of 1 Tetrapropyl-ammoniumhydroxide (TPAOH) / 2.8 SiO₂ / 22.4 Ethanol / 40 H₂O. This clear solution is aged under stirring at ambient temperature and then heated up to 80 °C during 3-5 days capped in a plastic vessel. Then, the nanoparticle suspension obtained is centrifuged at 5000 rpm for 20 minutes to remove big particles. The suspension is spun on Si wafers (substrates) at 3300 rpm during 20-30 seconds. The film obtained may be dried at 80 °C overnight.

### Example 2: UV cure of a zeolite film

For the examples, a single wafer UV exposure system (RapidCure^{™} from Axcelis) tool was used. Exposure with a microwave-driven electrodeless bulb emitting UV light with a broadband spectrum was used. Inert gas ambient and ambient pressure was used.

The wafer (substrate) with the pure-silica-zeolite film on top of it sits on a thermo chuck at temperature of 425°C.

The exposure time is 5 minutes and the spectrum of the UV emission is lower than 300nm.

### Example 3: Yield measurements (crystalinity)

The synthesized pure-silica-zeolite film had around 30% of zeolite nanocrystals (yield). The yield of said pure-silica-zeolite film after deposition is the percentage of silica belonging to zeolite nanocrystals in the order of 40-70nm, preferably 50-70nm. Thus, the final films in the example have around 30% of silica nanocrystals and the rest is amorphous silica. This amorphous phase contains zeolite seeds responsible of the creation of the silica nanocrystals, possibly nanoslabs and/or nanotablets as proposed by Kirschhock and co-authors.

The zeolite nanocrystals have a level of crystallinity and a particle size depending on the synthesis conditions (crystallization time, temperature...). There is a trade-off between particle size and level of crystallinity of the nanocrystals.

### Example 4: Porosity measurements

Zeolite films of the example without UV-cure have an open porosity of 37.6%, measured by Ellipsoporosimetry with toluene.

In the case of UV-cure the porosity is decreased to 27.9% because the film becomes denser.

Moreover there is an increase of refractive index in agreement with the densification of the film.

Clearly, the structure of the pure-silica-zeolite film is more cross-linked.

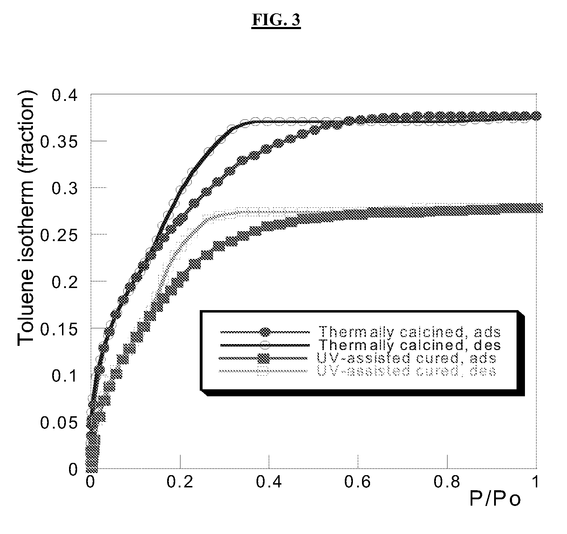

Figure 3 illustrates the porosity of the pure-silica-zeolite film after UV-cure from Ellipsometric measurements performed with toluene.

### Example 5: Contact angle measurements

The pure-silica-zeolite film after UV-cure according to the present invention (having a thermal activation during UV exposure) was evaluated for hydrophobicity by performing contact angle measurement.

For a given droplet on a substrate the contact angle is a measurement of the angle formed between the substrate and the line tangent to the droplet radius from the point of contact with the substrate.

The contact angle is related to the surface tension by the Young's equation through which the behavior of specific liquid-solid interactions can be calculated. A contact angle of zero results in complete wetting of the substrate, while an angle between 0 and 90 results in spreading of the drop (due to molecular attraction). Angles greater than 90 indicate that the liquid tends to bead or shrink away from the substrate, in case water is the liquid, the substrate can be interpreted as a hydrophobic substrate.

Contact angle measurements were done with water and a contact angle value of 118 (error is +-5) degrees was calculated fitting the curve to a Young-Laplace equation.

### Example 6: reduction of cracks

Zeolite films containing an amorphous part suffer shrinkage during the removal of the template by thermal treatment. This shrinkage is mainly related to the amorphous part among nanocrystals.

In the case of higher yields (high ratio of zeolite nanocrystals), this shrinkage leads to the formation of cracks in the films (as shown in Figure 5A), probably due to the collapsing of pores.

When zeolite films are used as insulator in chips, these cracks will lead to the failure of chips because these cracks will create defects on the Cu barrier permitting the Cu diffusion.

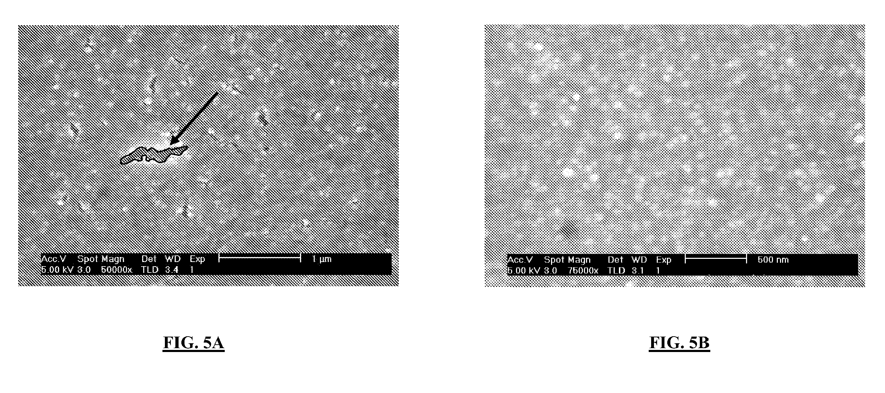

This is solved using the proposed UV-cure of the invention because although the shrinkage is practically the same, the better cross-linking of the zeolite film avoids the formation of cracks. The pure-silica-zeolite film after UV-cure is shown in Figure 5B and shows almost no cracks.

## Claims

1. A method for improving the hydrophobicity of a zeolite film comprising the steps of:
- providing a zeolite synthesis composition comprising a silica source and an organic template,
- forming onto a support a zeolite film,
- subjecting said formed zeolite film to, simultaneously, UV irradiation and thermal activation.

2. A method according to claim 1, wherein said zeolite film is formed on said support by an in-situ crystallization process.

3. A method according to claim 1, wherein said zeolite film is formed on said support by a dip-coating process.

4. A method according to claim 1, wherein said zeolite film is formed on said support by a spin-on process.

5. A method according to any of claims 1 to 4, wherein a suspension of zeolite nanocrystals, the particles size of which being comprised between 40 nm and 70 nm, is deposited on said support for forming said zeolite film.

6. A method according to claim 5, wherein said suspension of zeolite nanocrystals further comprises smaller silica nanoparticles or clusters of said smaller silica nanoparticles.

7. A method according to any of claims 1 to 6, wherein said zeolite film is a MEL, BEA, or preferably a MFI type.

8. A method according to any of claims 1 to 7, wherein said zeolite film is a pure-silica-zeolite film.

9. A method according to any of claims 1 to 8, wherein said support is selected from the group consisting of a substrate, a polymeric support, a porous alumina support, and a ceramic support.

10. A method according to any of claims 1 to 9, wherein said silica source comprises (or consists of) an organic silica such as tetraethyl orthosilicate (TEOS) and/or tetramethyl orthosilicate (TMOS), or an inorganic silica such as fumed silica, silica gel, or colloidal silica.

11. A method according to any of claims 1 to 10, wherein said organic template comprises (or consists of) an organic hydroxide such as a quaternary ammonium hydroxide.

12. A method according to claim 11, wherein said organic template is selected from the group consisting of tetrapropyl-ammonium hydroxide (TPAOH), tetraethylammonium hydroxide (TEAOH), triethyl-n-propyl ammonium hydroxide, and benzyl-trimethylammonium hydroxide.

13. A method according to any of claims 1 to 12, wherein the temperature for said thermal activation is higher than 100°C, preferably higher than 150°C, 200°C or 300°C, more preferably is comprised between about 350° and about 550°C.

14. A method according to claims 13, wherein said temperature is about 425°C.

15. A method according to any of claims 1 to 14, wherein the wavelengths of said UV irradiation are lower than 300 nm, preferably lower than 270 nm; more preferably comprised between 170 nm and 250 nm.

16. A method according to any of claims 1 to 15 further comprising, before the UV irradiation and thermal activation, a drying step.

17. A zeolite film obtainable by a method according to any of claims 1 to 16.

18. A semiconductor device comprising a zeolite film according to claim 17.

19. Use of a zeolite film according to claim 17 as low-k material.

20. Use a zeolite film according to claim 17 as a membrane.
